# EUROPEAN PATENT SPECIFICATION

(11) **EP 2 075 351 B1**
(45) Date of publication and mention of the grant of the patent: **12.09.2012**
(21) Application number: 08020612.1
(22) Date of filing: 27.11.2008
(51) Int. Cl.: C23C 14/20, C23C 14/02, C23C 14/58, B44C 1/22, B44F 1/06

(54) **A coated plastic sheet, a method for preparing same, and housing using same**
Beschichtete Kunststoffolie, Verfahren zu ihrer Herstellung, und Gehäuse damit
Feuille en matière plastique revêtue, procédé pour son obtention, et boitier l'utilisant

(30) Priority: 28.11.2007 CN 200710196526
(43) Date of publication of application: 01.07.2009
(73) Proprietor: Byd Company Limited, Shenzhen 518118 (CN)
(72) Inventor: Zhao, Lihong, Longgang, 518118 Shenzhen (CN); Wenhai Luo, Pingshan, Longgang 518118 Shenzhen (CN); Xijing Liu, Pingshan, Longgang 518118 Shenzhen (CN)
(74) Representative: Bulling, Alexander

(56) References cited:
- WO-A-2004/099460
- DE-A1- 3 509 519
- DE-A1- 10 047 083
- DE-A1- 10 155 906
- DE-A1- 10 208 674
- DE-A1-102005 006 459
- DE-A1-102007 015 625

## Description

The present application claims priority to Chinese Patent Application No. CN200710196526.1, filed November 28, 2007.

The present disclosure relates to a coated plastic sheet, a method for preparing same, and a housing using same.

Plastic housing is widely used in the electronic products since it has a light weight, a low price and other advantages. With the development of the portable electronic industry, the requirement of metallic housing is increasing. Conventional methods for forming a metallic texture on a plastic product are electroplating and physical vapor deposition (PVD). However, the resulting color of the metallic texture in these methods is relatively simplistic, and the patterns usually lack diversity. CN 1470677A discloses a method of laser carving and plating. The method comprises: selecting a transparent plastic material; retreating the front surface of the plastic material with a metallic paint; laser-carving the pretreated plastic material to form a required pattern; coating the whole back surface of the plastic material with a transparent anti-plating agent; and plating the plastic material. The process disclosed in CN 1470677A however is rather complex and can provide only simplistic color on the plated surface. The patterns also lack three-dimensional effect.

In one aspect, a coated plastic sheet according to claim 1 comprises a transparent plastic sheet having a top and bottom surface, and a first film on the top surface and covering less than all of the top surface, thereby creating at least one uncovered area. At least a portion of the first film has a first metallic luster on its exposed surface. The coated plastic sheet also comprises a second film on the bottom surface. At least a portion of the second film is visible through the uncovered area of the sheet, wherein the second film presents a second metallic luster through the uncovered area.

In another aspect, a method according to claim 8 for preparing a coated plastic sheet comprises forming a first film on a top surface of a transparent plastic sheet. The first film covers less than all of the top surface, thereby creating at least one uncovered area. At least a portion of the first film has a first metallic luster on its exposed surface. The method further comprises forming a second film on a bottom surface of the transparent plastic sheet. At least a portion of the second film is visible through the uncovered area of the sheet. The second film presents a second metallic luster through the uncovered area.

In yet another aspect, a housing according to claim 13 comprising a coated plastic sheet. The coated plastic sheet comprises a transparent plastic sheet having a top and bottom surface, and a first film on the top surface and covering less than all of the top surface, thereby creating at least one uncovered area. At least a portion of the first film has a first metallic luster on its exposed surface. The coated plastic sheet also comprises a second film on the bottom surface. At least a portion of the second film is visible through the uncovered area of the sheet, wherein the second film presents a second metallic luster through the uncovered area.
- Figure 1: is the cross-sectional view of the coated plastic sheet prepared in Example 1.
- Figure 2: is the front view of the coated plastic sheet according to one embodiment of the present invention.

According to one embodiment, a coated plastic sheet is provided. The coated plastic sheet comprises a transparent plastic sheet having a top and bottom surface. The coated plastic sheet further comprises a first film on the top surface and covering less than all of the top surface, thereby created at least one uncovered area. At least a portion of the first film has a first metallic luster on its exposed surface. The coated plastic sheet also comprises a second film on the bottom surface, at least a portion of which is visible through the uncovered area of the sheet. The second film presents a second metallic luster through the uncovered area. Preferably, the second film covers at least the part of the bottom surface corresponding to the uncovered area. More preferably, the second film covers substantially the whole bottom surface. The transparent plastic sheet may be translucent or color-tinted. Both the first film and the second film present a metallic luster when viewed from the top surface side. The first film and the second film present different colors.

The coating material of the first film and the second film are independently selected from the group consisting of Cu, Cr, Ti, Ag, Ni, Ag, Al, Zn, Sn, TiN, TiAlN, TiAlC, TiC, diamond-like carbon and combinations thereof.

The first film and the second film can be independently metallic paints. The metallic paints can be either front-view metallic paints or back-view metallic paints. When a front-view metallic paint is coated on a transparent material, it presents a metallic luster only when viewed from the coated surface side. It does not present any metallic luster when viewed from the uncoated surface side through the transparent material. Thus front-view metallic paints can only be used as the first film. Examples of front-view metallic paints include series DSMT200, series DSMT100, and series DSMT100P metallic paints from Guangzhou Color Paints Company. When a back-view metallic paint is coated on a transparent material, it presents a metallic luster only when viewed from the uncoated surface side through the transparent material. It does not present any metallic luster when viewed from the coated surface side. Thus the back-view metallic paint can only be used as the second film. Examples of back-view metallic paints include series MIT1000, series MI400-01, and series MI1000 metallic paints from Guangzhou Color Paints Company.

The thickness of the first film and the second film can be either identical or different, provided that it is larger than about 0.03 um. Preferably, it is in a range of about 0.05 to 3 um.

In order to achieve a high adhesive property of the surfaces, and to obtain a good coating on the top surface, the plastic sheet may further comprise a base layer disposed between the top surface and the first film. The base layer can be any suitable base coatings. For example, it can be selected from the group consisting of polyester acrylate, epoxy acrylate, polyurethane acrylate and combinations thereof.
In order to achieve a good wearing-resistance property of the plastic sheet, the plastic sheet may further comprise a finishing layer. The finishing layer is disposed on the exposed surface of the first film and/or the second film. The finishing layer can be any suitable finishing coatings. For example, it can be selected from the group consisting of polyester acrylate, epoxy acrylate, polyurethane acrylate and combinations thereof.

The transparent plastic material can be any suitable transparent plastic materials. For example, it can be selected from the group consisting of transparent polycarbonate (PC), acrylate-butadiene-styrene (ABS) and polymethylmethacrylate (PMMA) and combinations thereof.

In another embodiment, a method for preparing the coated plastic sheet is provided. The method comprises forming a first film on a top surface of a transparent plastic sheet. The first film covers less than all of the top surface, thereby created at least one uncovered area. At least a portion of the first film has a first metallic luster on its exposed surface. The method further comprises forming a second film on a bottom surface of the transparent plastic sheet. At least a portion of the second film is visible through the uncovered area of the sheet. The second film presents a second metallic luster through the uncovered area.

The first film may be formed by applying a coating material onto the top surface of the transparent plastic sheet, and then partially removing the first coating material according to a pre-determined pattern. The second film may be formed by applying a coating material onto the bottom surface of the transparent plastic sheet. The second film preferably covers at least the part of the bottom surface corresponding to the uncovered area. For convenience of operation, preferably, the second coating layer covers substantially the entire bottom surface.

The method for applying a coating onto the surface of the transparent plastic sheet can be any suitable method. For example, it can be electroplating, physical vapor deposition (PVD) (including vacuum evaporation, magnetron sputtering and ion plating), metal spraying, ink printing, or the like.

The method for partially removing the first coating material can be any suitable manual or mechanical method, provided it can remove the coating without substantially damaging the substrate. For example, it can be selected from the group consisting of hand-carving, laser carving, chemical etching and combinations thereof.

The first film and the second film are independently selected from the group consisting of Cu, Cr, Ti, Ag, Ni, Ag, Al, Zn, Sn, TiN, TiAlN, TiAlC, TiC, diamond-like carbon and combinations thereof.

The first film and the second film also can be independently metal paints. The metallic paints comprise front-view metallic paints and back-view metallic paints. When a front-view metallic paint is coated on a transparent material, it presents a metallic luster only when viewed from the coated surface side. It does not present any metallic luster when viewed from the uncoated surface side through the transparent material. Thus, front-view metallic paints can only be used as the first film. Examples of front-view metallic paints include series DSMT200, series DSMT100, and series DSMT100P metallic paints from Guangzhou Color Paints Company. When a back-view metallic paint is coated on a transparent material, it presents a metallic luster only when viewed from the uncoated surface side through the transparent material. It does not present any metallic luster when viewed from the coated surface side. Thus, back-view metallic paints can only be used as the second film. Examples of back-view metallic paints include series MIT1000, series MI400-01, and series MI1000 metallic paints from Guangzhou Color Paints Company.

In order to achieve a high adhesive property of the surfaces, and to obtain a good coating on the top surface, the plastic sheet further comprises a base layer disposed between the top surface and the first film. The base layer can be any suitable base coatings. For example, it can be selected from the group consisting of polyester acrylate, epoxy acrylate, polyurethane acrylate and combinations thereof.

In order to achieve a good wearing-resistance property of the plastic sheet, the plastic sheet further comprises a finishing layer. The finishing layer is disposed on the exposed surface of the first film and/or the second film. The finishing layer can be any suitable finishing coatings. For example, it can be selected from the group consisting of polyester acrylate, epoxy acrylate, polyurethane acrylate and combinations thereof.

The transparent plastic material can be any suitable transparent plastic materials. For example, it can be selected from the group consisting of transparent polycarbonate (PC), acrylate-butadiene-styrene (ABS) and polymethylmethacrylate (PMMA) and combinations thereof.

Preferably, the method for preparing the coated plastic sheet is as follows:
(1) select a transparent plastic sheet with smooth surfaces, such as transparent PC, ABS or PMMA;
(2) use alcohol or acetone to remove any impurity from both surfaces;
(3) spray a base coating material onto the top surface of the transparent plastic sheet to form a base layer with a thickness of about 8 to12 um;
(4) dry the base layer;
(5) apply a coating material onto the coated surface by physical vapor deposition (PVD) to form a first film;
(6) dry the first film;
(7) engrave a pre-determined pattern on the first film using laser carving, and control the carving depth by regulating the electric current of the laser source; preferably, the carving is deep enough to expose the plastic sheet;
(8) spray a back-view metallic paint onto the bottom surface of the transparent plastic sheet to form a second film;
(9) dry the second film; and
(10) spray a finishing coating material on the first film to form a finishing layer.

In yet another embodiment, a housing using the coated plastic sheet is provided. The housing is made of a plastic sheet with two coatings with a three-dimensional effect. The first surface of the plastic sheet is used as an exterior surface. The second surface is used as an inner surface. The housing can be used for any suitable products. For example, it can be used for cell phones, PDAs, MP3s, MP4s, computers, notebooks, pencil-boxes, artworks and other products.

The present invention is illustrated in detail by the below Examples and drawings.

### Example 1

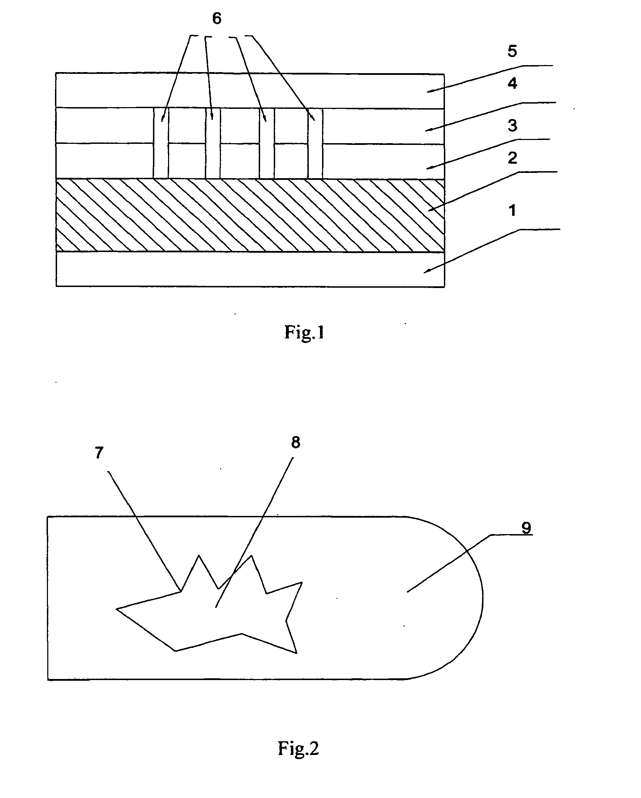

This example illustrates a method for preparing the plastic sheet as shown in Figure 1. The method comprises the following steps.
(i) Alcohol was used to clean both surfaces of a 0.9 mm thick transparent PC sheet (2).
(ii) Polyester acrylate was sprayed onto the top surface of the transparent plastic sheet to form a base layer (3); and the base layer has a thickness of about 10 um.
(iii) The base layer was dried.
(iv) Chromium was applied onto the coated surface by physical vapor deposition (PVD) to form the first film (4).
The detailed operation of step (iv) is as follows.
Plating type: sputter coating.
Plating material: chromium.
Pretreatment: O₂ was flushed at a speed of about 270 sccm (standard condition, cubic centimeter per minute) for about 5 seconds and ionized with about 600 W of RF (radio frequency power) for about 10 seconds. The PC sheet was cleaned in the oxygen ion atmosphere.
Plating: argon gas was flushed at a speed of about 90 sccm.
Total plating time is about 36 seconds. The change of the plating power with the time is shown in table 1.

**Table 1**

| Serial Number | 1 | 2 | 3 | 4 | 5 | 6 | 7 | 8 | 9 | 10 | 11 | 12 |
|---|---|---|---|---|---|---|---|---|---|---|---|---|
| Power (W) | 2500 | 3000 | 3500 | 4000 | 2500 | 3000 | 3500 | 4000 | 2500 | 3000 | 3500 | 4000 |
| Time (s) | 2 | 2 | 2 | 2 | 3 | 3 | 3 | 3 | 4 | 4 | 4 | 4 |

(v) The chromium plated plastic sheet was dried.
(vi) The first film was laser-engraved to form the required pattern (6), using an EPYAG25 laser equipment at an electric current of about 12 A.
(vii) A DSMT100P series metallic paint was prepared and sprayed on the bottom surface of the transparent plastic sheet to form the second film (1).
(viii) The second film was dried at about 70 degree for about 2 hours.
(ix) Polyester acrylic acid oligomer was sprayed on the first film and dried to form a finishing layer (5).

The plastic material with dual metallic tones was obtained. The external appearance of the obtained plastic sheet is showed in Figure 2. Line (7) is the edge of the required pattern (8). The area of the pattern (8) is not covered with the first film. Part (9) is the portion of the first film. The second film can be seen through the transparent plastic sheet in the area of the pattern (8). As a result, the plastic sheet product has a diversified dual metallic tone with three dimensional effects.

Many modifications and other embodiments of the present disclosure will come to mind to one skilled in the art to which the present disclosure pertains having the benefit of the teachings presented in the foregoing description; and it will be apparent to those skilled in the art that variations and modifications of the present disclosure can be made without departing from the scope of the present disclosure. Therefore, it is to be understood that the invention is not to be limited to the specific embodiments disclosed and that modifications and other embodiments are intended to be included within the scope of the appended claims. Although specific terms are employed herein, they are used in a generic and descriptive sense only and not for purposes of limitation.

## Claims

1. A coated plastic sheet, comprising:
a transparent plastic sheet having a top and bottom surface;
a first film on the top surface and covering less than all of the top surface, thereby creating at least one uncovered area, at least a portion of the first film has a first metallic luster on its exposed surface; and
a second film on the bottom surface, at least a portion of which is visible through the uncovered area of the sheet, wherein the second film presents a second metallic luster through the uncovered area,
wherein the first film and the second film independently comprise a metallic paint, or a coating material selected from the group consisting of Cu, Cr, Ti, Ag, Ni, Al, Zn, Sn, TiN, TiAIN, TiAlC, TiC, diamond-like carbon, and combinations thereof.

2. The coated plastic sheet of claim 1, wherein the second film covers substantially the entire bottom surface.

3. The coated plastic sheet of claim 1 or 2, wherein the second film presents the second metallic luster on substantially the entire uncovered area or on substantially the entire bottom surface.

4. The coated plastic sheet of any one of claims 1 to 3, wherein the first metallic luster and the second metallic luster are different in color.

5. The coated plastic sheet of any one of claims 1 to 4, wherein the thickness of the first film and the second film is independently in the range of about 0.05 to 3 µm.

6. The coated plastic sheet of any one of claim 1 to 5, further comprising a primer layer disposed between the top surface and the first film, or a finishing layer disposed on the first film and/or the second film, or both of the primer layer and the finishing layer.

7. The coated plastic sheet of claim 1, wherein the transparent plastic sheet comprises a material selected from the group consisting of polycarbonate, acrylonitrile-butadiene-styrene, polymethylmethacrylate, and combinations thereof.

8. A method for preparing a coated plastic sheet, comprising
forming a first film on a top surface of a transparent plastic sheet, the first film covering less than all of the top surface, thereby creating at least one uncovered area, at least a portion of the first film has a first metallic luster on its exposed surface; and
forming a second film on a bottom surface of the transparent plastic sheet, wherein at least a portion of the second film is visible through the uncovered area of the sheet, wherein the second film presents a second metallic luster through the uncovered area, preferably the second metallic luster and the first metallic luster are different in color,
wherein the first film and the second film independently comprise a metallic paint, or a coating material selected from the group consisting of Cu, Cr, Ti, Ag, Ni, Al, Zn, Sn, TiN, TiAIN, TiAlC, TiC, diamond-like carbon, and combinations thereof.

9. The method of claims 8, wherein forming the first film comprises:
applying a coating material onto the top surface of the transparent plastic sheet, preferably by electroplating, physical vapor deposition, metal spraying, or ink printing; and
partially removing the coating material from the top surface to form the first film and the uncoated area, preferably by hand-carving, laser carving, chemical etching, or combinations thereof, more preferably based on a pre-determined pattern.

10. The method of any one of claim 8 to 9, wherein forming the second film comprises:
applying a coating material onto the bottom surface of the transparent plastic sheet, preferably by electroplating, physical vapor deposition, metal spraying, or ink printing,
wherein, the second film is formed to, preferably cover substantially the entire bottom surface.

11. The method of any one of claim 8 to 10, further comprising one or more of the following step(s):
forming a primer layer on the top surface of the transparent plastic sheet,
forming a finishing layer on the first film, and
forming a finishing layer on the second film,

12. The method of any one of claims 8 to 11, wherein the transparent plastic sheet comprises a material selected from the group consisting of polycarbonate, acrylonitrile-butadiene-styrene, polymethylmethacrylate, and combinations thereof.

13. A housing comprising:
a coated plastic sheet, the coated plastic sheet comprising:
a transparent plastic sheet having a top and bottom surface;
a first film on the top surface and covering less than all of the top surface, thereby creating at least one uncovered area, at least a portion of the first film has a first metallic luster on its exposed surface; and
a second film on the bottom surface, at least a portion of which is visible through the uncovered area of the sheet, wherein the second film presents a second metallic luster through the uncovered area, wherein the first film and the second film independently comprise a metallic paint, or a coating material selected from the group consisting of Cu, Cr, Ti, Ag, Ni, Al, Zn, Sn, TiN, TiAIN, TiAlC, TiC, diamond-like carbon, and combinations thereof.

## Patentansprüche

1. Beschichtete Kunststofffolie, die aufweist:
eine transparente Kunststofffolie mit einer oberen und
einer unteren Oberfläche;
einen ersten Film auf der oberen Oberfläche, der weniger als die gesamte obere Oberfläche bedeckt, wodurch mindestens ein unbedeckter Bereich geschaffen wird, wobei mindestens ein Abschnitt des ersten Films einen ersten metallischen Schimmer auf seiner offenliegenden Oberfläche besitzt; und
einen zweiten Film auf der unteren Oberfläche, von dem mindestens ein Abschnitt durch den unbedeckten Bereich der Folie hindurch sichtbar ist, wobei der zweite Film einen zweiten metallischen Schimmer durch den unbedeckten Bereich hindurch besitzt,
wobei der erste Film und der zweite Film unabhängig einen metallischen Anstrichstoff oder ein Beschichtungsmaterial, das aus der Gruppe, bestehend aus Cu, Cr, Ti, Ag, Ni, Al, Zn, Sn, TiN, TiAlN, TiAlC, TiC, diamantähnlichem Kohlenstoff und Kombinationen daraus, ausgewählt wird, aufweisen.

2. Beschichtete Kunststofffolie nach Anspruch 1, wobei der zweite Film im Wesentlichen die gesamte untere Oberfläche bedeckt.

3. Beschichtete Kunststofffolie nach Anspruch 1 oder 2, wobei der zweite Film den zweiten metallischen Schimmer in im Wesentlichen dem gesamten unbedeckten Bereich oder auf im Wesentlichen der gesamten unteren Oberfläche aufweist.

4. Beschichtete Kunststofffolie nach einem der Ansprüche 1 bis 3, wobei der erste metallische Schimmer und der zweite metallische Schimmer von unterschiedlicher Farbe sind.

5. Beschichtete Kunststofffolie nach einem der Ansprüche 1 bis 4, wobei die Dicke des ersten Films und des zweiten Films unabhängig im Bereich von etwa 0,05 bis 3 µm liegt.

6. Beschichtete Kunststofffolie nach einem der Ansprüche 1 bis 5, ferner mit einer Grundierschicht, die sich zwischen der oberen Oberfläche und dem ersten Film befindet, oder einer Deckschicht, die sich auf dem ersten Film und/oder dem zweiten Film befindet, oder sowohl der Grundierschicht als auch der Deckschicht.

7. Beschichtete Kunststofffolie nach Anspruch 1, wobei die transparente Kunststofffolie ein Material, das aus der Gruppe, bestehend aus Polycarbonat, Acrylnitril-Butadien-Styrol, Polymethylmethacryclat und Kombinationen daraus, ausgewählt ist, aufweist.

8. Verfahren zum Herstellen einer beschichteten Kunststofffolie, das beinhaltet
Bilden eines ersten Films auf einer oberen Oberfläche einer transparenten Kunststofffolie, wobei der erste Film weniger als die gesamte obere Oberfläche bedeckt, wodurch mindestens ein unbedeckter Bereich geschaffen wird, wobei mindestens ein Abschnitt des ersten Films einen ersten metallischen Schimmer auf seiner offenliegenden Oberfläche besitzt; und
Bilden eines zweiten Films auf einer unteren Oberfläche der transparenten Kunststofffolie, wobei mindestens ein Abschnitt des zweiten Films durch den unbedeckten Bereich der Folie hindurch sichtbar ist, wobei der zweite Film einen zweiten metallischen Schimmer durch den unbedeckten Bereich hindurch aufweist, vorzugsweise der zweite metallische Schimmer und der erste metallische Schimmer von unterschiedlicher Farbe sind,
wobei der erste Film und der zweite Film unabhängig einen metallischen Anstrichstoff oder ein Beschichtungsmaterial, das aus der Gruppe, bestehend aus Cu, Cr, Ti, Ag, Ni, Al, Zn, Sn, TiN, TiAlN, TiAlC, TiC, diamantähnlichem Kohlenstoff und Kombinationen daraus, ausgewählt wird, aufweisen.

9. Verfahren nach Anspruch 8, wobei das Bilden des ersten Films beinhaltet:
Auftragen eines Beschichtungsmaterials auf die obere Oberfläche der transparenten Kunststofffolie, vorzugsweise durch galvanisches Beschichten, physikalisches Aufdampfen, Metallspritzen oder Aufdrucken von Farbe; und
teilweises Entfernen des Beschichtungsmaterials von der oberen Oberfläche, um den ersten Film und den unbeschichteten Bereich zu bilden, vorzugsweise durch Abtragen von Hand, Abtragen mit Laser, chemisches Ätzen oder Kombinationen daraus, noch mehr vorzuziehen auf der Basis eines vorgegebenen Musters.

10. Verfahren nach einem der Ansprüche 8 bis 9, wobei das Bilden des zweiten Films beinhaltet:
Auftragen eines Beschichtungsmaterials auf die untere Oberfläche der transparenten Kunststofffolie, vorzugsweise durch galvanisches Beschichten, physikalisches Aufdampfen, Metallspritzen oder Aufdrucken von Farbe,
wobei der zweite Film gebildet wird, um vorzugsweise im Wesentlichen die gesamte untere Oberfläche zu bedecken.

11. Verfahren nach einem der Ansprüche 8 bis 10, ferner beinhaltend einen oder mehr der folgenden Schritte:
Bilden einer Grundierschicht auf der oberen Oberfläche der transparenten Kunststofffolie,
Bilden einer Deckschicht auf dem ersten Film und
Bilden einer Deckschicht auf dem zweiten Film.

12. Verfahren nach einem der Ansprüche 8 bis 11, wobei die transparente Kunststofffolie ein Material, das aus der Gruppe, bestehend aus Polycarbonat, Acrylnitril-Butadien-Styrol, Polymethylmethacryclat und Kombinationen daraus, ausgewählt wird, aufweist.

13. Gehäuse mit:
einer beschichteten Kunststofffolie, wobei die beschichtete Kunststofffolie aufweist:
eine transparente Kunststofffolie mit einer oberen und
einer unteren Oberfläche;
einen ersten Film auf der oberen Oberfläche, der weniger als die gesamte obere Oberfläche bedeckt, wodurch mindestens ein unbedeckter Bereich geschaffen wird, wobei mindestens ein Abschnitt des ersten Films einen ersten metallischen Schimmer auf seiner offenliegenden Oberfläche besitzt; und
einen zweiten Film auf der unteren Oberfläche, von dem mindestens ein Abschnitt durch den unbedeckten Bereich der Folie hindurch sichtbar ist, wobei der zweite Film einen zweiten metallischen Schimmer durch den unbedeckten Bereich hindurch besitzt,
wobei der erste Film und der zweite Film unabhängig einen metallischen Anstrichstoff oder ein Beschichtungsmaterial, das aus der Gruppe, bestehend aus Cu, Cr, Ti, Ag, Ni, Al, Zn, Sn, TiN, TiAlN, TiAlC, TiC, diamantähnlichem Kohlenstoff und Kombinationen daraus, ausgewählt wird, aufweisen.

## Revendications

1. Feuille plastique revêtue comprenant:
une feuille plastique transparente ayant une surface de dessus et une surface de dessous;
un premier film sur la surface de dessus, qui couvre moins que la totalité de la surface de dessus, en créant ainsi au moins une zone non recouverte, au moins une partie du premier film ayant un premier lustre métallique sur sa surface exposée; et
un deuxième film sur la surface de fond, dont au moins une partie est visible à travers la zone non recouverte de la feuille, le deuxième film présentant un deuxième lustre métallique à travers la zone non recouverte,
dans laquelle le premier film et le deuxième film comprennent indépendamment une peinture métallique, ou un matériau de revêtement choisi dans le groupe constitué par Cu, Cr, Ti, Ag, Ni, Al, Zn, Sn, TiN, TiAIN, TiAlC, TiC, le carbone de type diamant, et leurs combinaisons.

2. Feuille plastique revêtue selon la revendication 1, dans laquelle le deuxième film recouvre pratiquement toute la surface de fond.

3. Feuille plastique revêtue selon la revendication 1 ou 2, dans laquelle le deuxième film présente le deuxième lustre métallique sur pratiquement toute la surface non recouverte ou sur pratiquement toute la surface de fond.

4. Feuille plastique revêtue selon l'une quelconque des revendications 1 à 3, dans laquelle le premier lustre métallique et le deuxième lustre métallique ont des couleurs différentes.

5. Feuille plastique revêtue selon l'une quelconque des revendications 1 à 4, dans laquelle les épaisseurs du premier film et du deuxième film sont indépendamment situées dans la plage allant d'environ 0,05 à 3 µm.

6. Feuille plastique revêtue selon l'une quelconque des revendications 1 à 5, comprenant en outre une couche d'apprêt disposée entre la surface de dessus et le premier film, ou une couche de finition disposée sur le premier film et/ou le deuxième film, ou à la fois la couche d'apprêt et la couche de finition.

7. Feuille plastique revêtue selon la revendication 1, dans laquelle la feuille plastique transparente comprend un matériau choisi dans le groupe constitué par le polycarbonate, l'acrylonitrile-butadiène-styrène, le poly(méthacrylate de méthyle), et leurs combinaisons.

8. Procédé pour préparer une feuille plastique revêtue, comprenant
la formation d'un premier film sur une surface de dessus d'une feuille plastique transparente, le premier film couvrant moins que la totalité de la surface de dessus, ce qui crée ainsi au moins une zone non recouverte, au moins une partie du premier film ayant un premier lustre métallique sur sa surface exposée; et
la formation d'un deuxième film sur une surface de fond de la feuille plastique transparente, au moins une partie du deuxième film étant visible à travers la zone non recouverte de la feuille, le deuxième film présentant un deuxième lustre métallique à travers la zone non recouverte, de préférence le deuxième lustre métallique et le premier lustre métallique ayant des couleurs différentes,
dans lequel le premier film et le deuxième film comprennent indépendamment une peinture métallique, ou un matériau de revêtement choisi dans le groupe constitué par Cu, Cr, Ti, Ag, Ni, Al, Zn, Sn, TiN, TiAlN, TiAlC, TiC, le carbone de type diamant, et leurs combinaisons.

9. Procédé selon la revendication 8, dans lequel la formation du premier film comprend:
l'application d'un matériau de revêtement sur la surface de dessus de la feuille plastique transparente, de préférence par placage électrolytique, déposition physique de vapeur, pulvérisation de métal, ou impression d'encre; et
le retrait partiel du matériau de revêtement sur la surface de dessus pour former le premier film et la zone non revêtue, de préférence par gravure à la main, gravure au laser, décapage chimique, ou leurs combinaisons, mieux encore sur la base d'un motif prédéterminé.

10. Procédé selon l'une quelconque des revendications 8 et 9, dans lequel la formation du deuxième film comprend:
l'application d'un matériau de revêtement sur la surface de dessous de la feuille plastique transparente, de préférence par placage électrolytique, déposition physique de vapeur, pulvérisation de métal, ou impression d'encre,
dans lequel le deuxième film est formé de préférence de manière à recouvrir pratiquement toute la surface de fond.

11. Procédé selon l'une quelconque des revendications 8 à 10, comprenant en outre une ou plusieurs des étapes suivantes:
la formation d'une couche d'apprêt sur la surface de dessus de la feuille plastique transparente,
la formation d'une couche de finition sur le premier film, et
la formation d'une couche de finition sur le deuxième film.

12. Procédé selon l'une quelconque des revendications 8 à 11, dans lequel la feuille plastique transparente comprend un matériau choisi dans le groupe constitué par le polycarbonate, l'acrylonitrile-butadiène-styrène, le poly(méthacrylate de méthyle), et leurs combinaisons.

13. Boîtier comprenant:
une feuille plastique revêtue, la feuille plastique revêtue comprenant:
une feuille plastique transparente ayant une surface de dessus et une surface de dessous;
un premier film sur la surface de dessus, qui couvre moins que la totalité de la surface de dessus, en créant ainsi au moins une zone non recouverte, au moins une partie du premier film ayant un premier lustre métallique sur sa surface exposée; et
un deuxième film sur la surface de fond, dont au moins une partie est visible à travers la zone non recouverte de la feuille, le deuxième film présentant un deuxième lustre métallique à travers la zone non recouverte,
dans lequel le premier film et le deuxième film comprennent indépendamment une peinture métallique, ou un matériau de revêtement choisi dans le groupe constitué par Cu, Cr, Ti, Ag, Ni, Al, Zn, Sn, TiN, TiAIN, TiAlC, TiC, le carbone de type diamant, et leurs combinaisons.
